Europäisches Patentamt

European Patent Office

Office européen des brevets

(19)

(11) Numéro de publication : **0 490 759 A1**

# (12) DEMANDE DE BREVET EUROPEEN

(21) Numéro de dépôt : **91403344.4**

(22) Date de dépôt : **10.12.91**

(51) Int. Cl.⁵ : **H01L 21/225**

(30) Priorité : **14.12.90 FR 9015682**

(43) Date de publication de la demande :
**17.06.92 Bulletin 92/25**

(84) Etats contractants désignés :
**DE GB NL**

(71) Demandeur : **THOMSON COMPOSANTS
MICROONDES
51, Esplanade du Général de Gaulle
F-92800 Puteaux (FR)**

(72) Inventeur : **Debrie, Francis
THOMSON-CSF, SCPI, Cédex 67
F-92045 Paris la Défense (FR)**
Inventeur : **Garnier, Christophe
THOMSON-CSF, SCPI, Cédex 67
F-92045 Paris la Défense (FR)**
Inventeur : **Diaz, Jacques
THOMSON-CSF, SCPI, Cédex 67
F-92045 Paris la Défense (FR)**
Inventeur : **Grisollet, Anne-Marie
THOMSON-CSF, SCPI, Cédex 67
F-92045 Paris la Défense (FR)**
Inventeur : **Schwob, Véronique
THOMSON-CSF, SCPI, Cédex 67
F-92045 Paris la Défense (FR)**

(74) Mandataire : **Taboureau, James et al
THOMSON-CSF SCPI
F-92045 Paris La Défense Cédex 67 (FR)**

(54) **Procédé de réalisation des métallisations sur un dispositif semiconducteur.**

(57)     L'invention concerne la réalisation des électrodes sur les diodes ou transistors à jonction métal/semiconducteur, après implantation d'ions dans le matériau semiconducteur.

Le recuit de la région implantée (3) dans la tranche de Si ou GaAs (1) exige une couche d'encapsulation (6) pour protéger la tranche (1). Selon l'invention, cette couche est en métal réfractaire, tel que W, Ti... qui ne nécessite pas d'être retiré pour pouvoir déposer une électrode (7).

Application à la réalisation de transistors et circuits intégrés, avec implantation.

FIG.8

EP 0 490 759 A1

La présente invention concerne un procédé de dépôt des métallisations d'électrodes sur la surface de dispositifs semiconducteurs comprenant au moins une région dans laquelle sont implantés des ions dopants.

Ce procédé comporte l'emploi d'une couche de métal réfractaire comme encapsulant du dispositif semiconducteur au cours des opérations de recuit.

On sait que les dispositifs semiconducteurs, quels qu'ils soient, simples transistors ou circuits intégrés, comportent au moins deux couches, pour former une jonction, et que l'une de ces deux couches est formée soit par diffusion d'impuretés, soit par implantation d'ions, afin de doper cette couche et en changer le type de conductivité.

Le silicium admet facilement les deux techniques, mais les matériaux du groupe III-V, tels que par exemple GaAs, AlGaAs, InP... etc, ne peuvent qu'être implantés, et ne supportent pas les opérations de diffusion, à hautes températures. Or, après une implantation d'ions, qui désorganise plus ou moins le réseau cristallin, il est nécessaire d'opérer un recuit en température, pour réorganiser le réseau cristallin et activer ainsi les espèces implantées. C'est pourquoi, très généralement, on réalise, avant l'implantation, une encapsulation de la tranche de matériau semiconducteur par une couche de protection, qui portégera la surface de ce matériau au cours du recuit à haute température - mais qui est cependant inférieure à la température d'une diffusion -.

Cette couche de protection est le plus souvent un diélectrique, et il sera nécessaire de la retirer en au moins une région, de façon à pouvoir déposer au moins une métallisation d'électrode. L'opération de gravure, qu'elle soit chimique ou physique - bombardement, plasma ... etc - est dommageable pour la couche qui a été implantée.

L'invention propose de remplacer la couche de matériau diélectrique - qu'il faut graver avant de déposer une métallisation d'électrode - par une couche de métal réfractaire - qu'on peut graver après avoir déposé une métallisation d'électrode, qui sert de masque -.

De façon plus précise, l'invention concerne un procédé de réalisation des métallisations à la surface d'un dispositif semiconducteur comportant au moins une région implantée dans une tranche de matériau semiconducteur, ce procédé étant caractérisé en ce que la couche d'encapsulation, déposée sur la tranche de matériau semiconducteur en vue de permettre le recuit de la région implantée, est une couche de métal réfractaire.

L'invention sera mieux comprise par la description détaillée qui suit, prise en comparaison avec un procédé classique, en s'appuyant sur les figures jointes en annexe, qui représentent :

– figures 1 à 4 : différentes étapes d'un procédé selon l'art connu,

– figures 5 à 8 : les étapes correspondantes, dans le procédé selon l'invention.

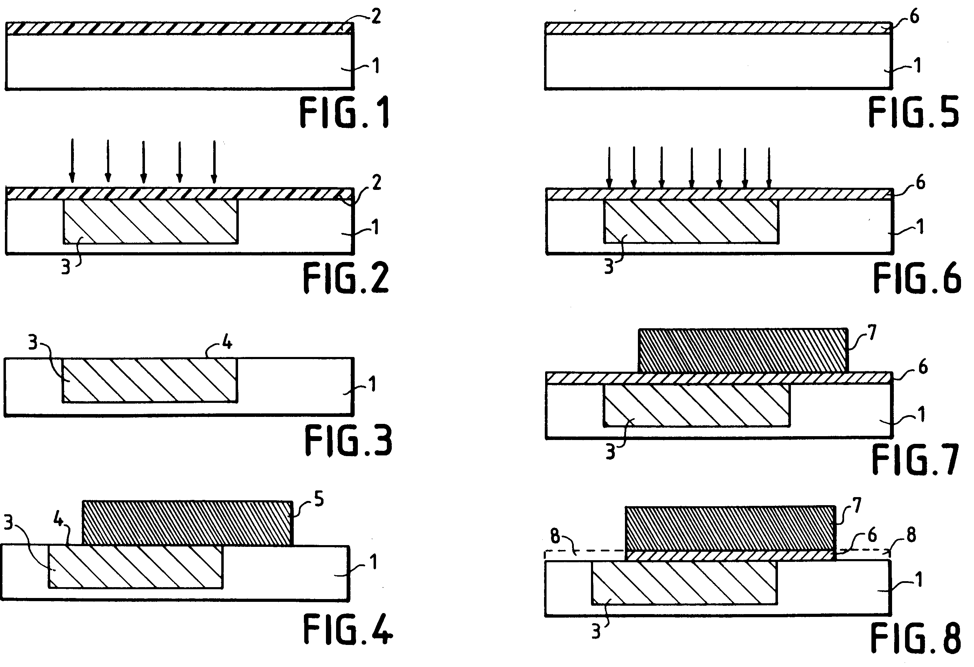

On comprendra mieux l'intérêt du procédé selon l'invention en le comparant avec un procédé connu, dont les principales étapes sont illustrées en figures 1 à 4, qui ne prennent en compte qu'une seule région implantée et une seule électrode. Selon le type de dispositif semiconducteur envisagé - diode, transistor, circuit intégré - l'homme de l'art voit immédiatement qu'il faut réaliser une zone implantée plus grande, ou plus petite, ou qu'il faut plusieurs métallisations. Il en est de même pour les figures de l'invention.

Selon l'art connu, pour déposer une métallisation d'électrode sur une région implantée, on commence par encapsuler une tranche 1 de matériau semiconducteur à l'intérieur d'une couche 2 de matériau diélectrique, tel que $SiO_2$, $Si_3 N_4$, AlN etc. . . . La figure 1 ne représente que la région utile pour exposer le procédé, et, dans la réalité des faits, le corps 1 peut comprendre un substrat, différentes couches de natures différentes, des caissons etc..., et la couche 2 enveloppe toute la tranche 1.

La tranche de matériau semiconducteur étant ainsi protégée, une région est transformée, en figure 2, par implantation ionique, symbolisée par des flèches. Cette région 3 peut être, par exemple, la couche active d'un transistor à effet de champ, ou un caisson de type n dans un substrat de silicium de type p. Après implantation, la couche d'encapsulation 2 permet le recuit.

Si la structure du dispositif en cours de fabrication nécessite de prendre un contact électrique, par une métallisation, sur cette région implantée 3, il faudra supprimer la couche 2 de diélectrique au moins à l'emplacement du futur contact. A moins, bien entendu, qu'il ne s'agisse d'un MOS, MIS, IGFET etc..., qui comportent une couche de diélectrique.

Supprimer la couche 2 de diélectrique, pour obtenir la structure de la figure 3, est une opération banale, mais dont on connaît bien les inconvénients. Si la gravure de la couche 2 a lieu par des procédés physiques, par voie sèche (bombardement, RIE... ) le réseau cristallin est détruit en surface, ce qui est surtout grave à la surface 4 de la région implantée 3. Si la gravure de la couche 2 a lieu par des procédés chimiques, par voie humide, la surface 4 peut retenir, par pollution, des ions des liquides d'attaque. Et dans tous les cas, la surface 4, qui n'est pas passivée, est exposée à la pollution atmosphérique.

Ensuite, il est facile de déposer, selon la figure 4, une métallisation 5 de prise de ce contact sur la région implantée 3 : quelle que soit la nature de cette jonction métal-semiconducteur, ohmique ou Schottky, on sait que la surface 4 a été dégradée au cours de l'opération précédente. Ce qui signifie que les caractéristiques physiques de la jonction région implantée 3/ métallisation 5 sont modifiées.

Pour éviter cet inconvénient, le procédé selon l'invention propose de remplacer la couche 2 de diélectrique par une couche 6 de métal réfractaire.

Les deux premières figures 5 et 6 du procédé selon l'invention sont très proches des premières figures du procédé connu, mais la couche 2 de SiO$_2$, Si$_3$N$_4$ ou AlN est remplacée par une couche 6, d'épaisseur 500 angströms environ, de métal réfractaire tel que W, Ti, WSi, Ti Si, Ta Si, etc... . En figure 6, on crée une région implantée 3 dans la tranche 1 de matériau semiconducteur par implantation d'ions dopants (B,As, P pour le Si) (Se, Si (n), Be, Mg (p) pour le GaAs) à travers la couche 6 de métal réfractaire, sous une énergie d'implantation comprise entre 10 et 200 KeV.

Les ions implantés dans la région 3 sont activés à haute température ( 850° C 10 min, ou 950° C 4 secondes) pour créer, par exemple, une couche active 3. La couche 6 de métal réfractaire, qui encapsule la tranche 1 la protège pendant cette opération de recuit.

Une différence capitale par rapport à l'art connu est que la couche de métal 6 est conductrice, tandis que la couche de diélectrique 2 ne l'était pas. Il est donc possible, en fig. 7, de déposer une électrode à l'emplacement prévu, dans le procédé de réalisation, sans dégager la surface de la tranche 1 et de la région implantée 3 qui continuent à être protégées par la couche métallique 6. De telle sorte que le contact électrique entre l'électrode et la couche implantée 3 est réalisé par la couche 6 de métal réfractaire, et l'interface 3/6 est exempt de défauts ou de pollutions chimiques, puisque la surface de la couche implantée 3 n'a pas été mise à nu, ni par des procédés physiques, ni par des procédés chimiques. La couche 7 forme l'armature supérieure d'une électrode : comprise entre 1000 angströms et quelques microns, elle est par exemple en or.

Il est avantageux de prévoir la réalisation des pistes conductrices d'interconnexions entre composants au cours de la même opération de réalisation des électrodes. Même si ces pistes conductrices ne sont pas disposées sur des régions implantées, cela évite une opération ultérieure de métallisation et de gravure.

Néanmoins, la couche 6 de métal réfractaire recouvre l'ensemble de la plaquette 1 de matériau semiconducteur, et court-circuite les différents composants qui y sont réalisés. Il faut donc, comme représenté en figure 8, la graver pour retirer toutes les parties 8, représentées en pointillé, quine sont pas protégées par les métallisations 7 qui agissent comme masques. Cette gravure se fait par des procédés connus : par exemple par plasma réactif à base de CF$_4$ ou SF$_6$.

Le procédé selon l'invention permet de réaliser des contacts ohmiques ou Schottky, sur silicium ou sur des matériaux du groupe III-V tels que GaAs, dans lesquels sont effectués au moins une implantation suivie d'un recuit. En effet, les métaux réfractaires donnent soit un contact ohmique, soit un contact Schottky selon divers paramètres : nature des métaux, implantation d'ions dopants, cinétique du recuit.

## Revendications

**1 -** Procédé de réalisation des métallisations à la surface d'un dispositif semiconducteur comportant au moins une région implantée (3) dans une tranche (1) de matériau semiconducteur, ce procédé étant caractérisé en ce que la couche (6) d'encapsulation, déposée sur la tranche (1) de matériau semiconducteur en vue de permettre le recuit de la région implantée (3), est une couche de métal réfractaire.

**2 -** Procédé de réalisation de métallisations selon la revendication 1, caractérisé en ce qu'il comporte les étapes suivantes :

– sur une tranche (1) de matériau semiconducteur, dépôt d'une couche (6) d'encapsulation en métal réfractaire, sur une épaisseur de l'ordre de 500 A°,

– à travers cette couche métallique (6), implantation d'ions dopants dans au moins une région implantée (3)

– recuit à haute température, à 850 - 950° C, de la région implantée (3), pour activer les ions dopants

– dépôt d'au moins une métallisation d'électrode (7) sur la couche (6) en métal réfractaire, à l'aplomb d'au moins ladite région implantée (3)

– gravure, par procédés physiques ou chimiques, de la couche (6) en métal réfractaire, hors des zônes (8) où ladite métallisation d'électrode (7) sert de masque.

**3 -** Procédé de réalisation de métallisations selon la revendication 1, caractérisé en ce que le métal réfractaire de la couche (6) d'encapsulation est choisi parmi : W, Ti, WSi, TiSi, TaSi.

FIG.1

FIG.2

FIG.3

FIG.4

FIG.5

FIG.6

FIG.7

FIG.8

EP 0 490 759 A1

Office européen
des brevets

**RAPPORT DE RECHERCHE EUROPEENNE**

Numero de la demande

EP    91 40 3344

| **DOCUMENTS CONSIDERES COMME PERTINENTS** | | | |
|---|---|---|---|
| Catégorie | Citation du document avec indication, en cas de besoin, des parties pertinentes | Revendication concernée | CLASSEMENT DE LA DEMANDE (Int. Cl.5 ) |
| A | IEEE TRANSACTIONS ON ELECTRON DEVICES. vol. 35, no. 12, Décembre 1988, NEW YORK US pages 2328 - 2332; MASANORI FUKUMOTO ET.AL.: 'Titanium silicide Interconnect Technology for Submicrometer DRAM's' * page 2328, alinéa 5 * ----- | 1 | H01L21/225 |
| | | | **DOMAINES TECHNIQUES RECHERCHES (Int. Cl.5 )** |
| | | | H01L |

Le présent rapport a été établi pour toutes les revendications

| Lieu de la recherche | Date d'achèvement de la recherche | Examinateur |
|---|---|---|
| LA HAYE | 31 MARS 1992 | N.J. PHEASANT |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)